(19) Europäisches Patentamt
European Patent Office
Office européen des brevets

(11) **EP 1 338 092 B1**

(12) **FASCICULE DE BREVET EUROPEEN**

(45) Date de publication et mention
de la délivrance du brevet:
**06.09.2006 Bulletin 2006/36**

(51) Int Cl.:
***H03M 13/15*** *(2006.01)*     ***H03M 13/45*** *(2006.01)*

(21) Numéro de dépôt: **01997184.5**

(22) Date de dépôt: **14.11.2001**

(86) Numéro de dépôt international:
**PCT/FR2001/003572**

(87) Numéro de publication internationale:
**WO 2002/043250 (30.05.2002 Gazette 2002/22)**

(54) **DECODAGE SOUPLE DE CODES EN BLOC AVEC DECODAGE D'ERREURS ET D'EFFACEMENTS**

WEICHE DEKODIERUNG VON BLOCK CODES MIT DEKODIERUNG VON FEHLERN UND AUSLÖSCHUNGEN

SOFT DECISION DECODING OF BLOCK CODES WITH ERROR AND ERASURE DECODING

(84) Etats contractants désignés:
**AT BE CH CY DE DK ES FI FR GB GR IE IT LI LU MC NL PT SE TR**

(30) Priorité: **27.11.2000 FR 0015266**

(43) Date de publication de la demande:
**27.08.2003 Bulletin 2003/35**

(73) Titulaire: **EADS Secure Networks**
**78180 Montigny le Bretonneux (FR)**

(72) Inventeur: **RENAUD, Christine**
**F-92500 Rueil-Malmaison (FR)**

(74) Mandataire: **Loisel, Bertrand**
**Cabinet Plasseraud**
**65/67 rue de la Victoire**
**75440 Paris Cedex 09 (FR)**

(56) Documents cités:
**DE-A- 4 316 813**     **US-A- 4 653 051**
**US-A- 4 675 869**     **US-A- 5 712 861**
**US-A- 6 047 395**

- **BATE S, HONARY B., FARRELL P.: "Error control techniques applicable to HF channels" IEE PROCEEDINGS ON SOLID-STATE & ELECTON DEVICES, no. 1, 1 février 1989 (1989-02-01), pages 57-63, XP000047678**
- **POEGEL F, FINGER A.: "Successive-Erasure Decoding of RS Codes and Error Detection for ARQ" PROCEEDINGS OF THE NINTH INTERNATIONAL SYMPOSIUM ON PERSONAL, INDOOR AND MOBILE RADIO COMMUNICATIONS, PIMRC'98, IEEE, vol. 3, 8 septembre 1998 (1998-09-08), - 11 septembre 1998 (1998-09-11) pages 1330-1334, XP010314637**

**Description**

La présente invention concerne les techniques de décodage des codes à redondance utilisés pour protéger des informations numériques contre les erreurs susceptibles d'apparaître pendant leur transmission ou leur stockage.

La présente invention s'applique en particulier aux codes de type Reed-Solomon couramment utilisés à cette fin.

On considère par exemple un code de Reed-Solomon RS(N, N-2t, t) défini sur un corps fini, ou corps de Galois, $CG(2^m)$ de cardinal $2^m$. Un code de Reed-Solomon est un code cyclique en blocs dont le polynôme générateur g(x) de degré 2t, à coefficients dans $CG(2^m)$, a pour racines 2t puissances consécutives d'un élément primitif $\alpha$ du corps $CG(2^m)$ :

$$g(x) = \prod_{i=1}^{2t} \left(x - \alpha^i\right) \qquad (1)$$

Chaque mot de code se compose de N symboles ($N < 2^m$) du corps $CG(2^m)$ qui représentent N-2t symboles d'information indépendants. Le nombre t est le nombre maximum de symboles erronés que le code permet de corriger algébriquement sans information a priori sur leurs positions. Chaque bloc reçu par le décodeur se compose de N symboles de $CG(2^m)$ $r_0, r_1,..., r_{N-1}$ définissant le polynôme :

$$R(x) = r_{N-1}.x^{N-1} + ... + r_1.x + r_0 \qquad (2)$$

En l'absence d'erreurs sur les symboles reçus, le polynôme générateur du code g(x) est un facteur de ce polynôme R(x).

Les méthodes de décodage font généralement intervenir des calculs de syndromes d'erreur. Un syndrome est une valeur du polynôme R(x) pour un élément donné du corps de Galois. Le plus souvent, on se limite au calcul des syndromes pour les 2t racines du polynôme générateur du code : $S_i = R(\alpha^i)$ pour $1 \le i \le 2t$. Si le bloc reçu comporte V symboles erronés $r_{h(0)}, r_{h(1)},...., r_{h(V-1)}$, avec $V \le t$ et $0 \le h(v) < N$ pour $0 \le v < V$, alors chaque syndrome $S_i$ vérifie :

$$S_i = \sum_{v=0}^{V-1} \alpha^{i.h(v)}.e_{h(v)} \qquad (3)$$

où $e_{h(v)}$ désigne l'amplitude de l'erreur sur le symbole $r_{h(v)}$.

Une manière classique de calculer un syndrome $S_i$ est d'utiliser une procédure récursive ou un circuit consistant essentiellement en un multiplieur, un additionneur et un registre pour mettre en oeuvre la relation de récurrence

$$S_i^{(n)} = S_i^{(n-1)}.\alpha^i + r_{N-1-n} \qquad (4)$$

Avec la condition d'initialisation $S_i^{(0)} = r_{N-1}$, le syndrome Si peut être calculé au fur et à mesure de l'arrivée des symboles $r_{N-1-n}$ (dans l'ordre des poids décroissants), et obtenu dès l'arrivée du dernier symbole $r_0$ du bloc: $S_i = S_i^{(N-1)}$.

Les 2t relations (3) ont 2V inconnues, à savoir les positions h(v) et les amplitudes $e_{h(v)}$ des erreurs. Pour résoudre ces équations, la plupart des algorithmes de décodage impliquent le calcul d'un polynôme localisateur d'erreurs $\sigma(x)$ de degré V dont les racines sont les éléments du corps de Galois de la forme $\alpha^{-h(v)}$. L'expression du polynôme localisateur d'erreurs est :

$$\sigma(x) = \kappa.\prod_{v=0}^{V} \left(1 - x.\alpha^{h(v)}\right) = \sigma_t.x^t + \sigma_{t-1}.x^{t-1} + ... + \sigma_1.x + \sigma_0 \qquad (5)$$

où $\kappa = \sigma_0$ est un élément arbitraire du corps $CG(2^m)$ et $\sigma_u = 0$ pour $u > V$. Les coefficients $\sigma_u$ de ce polynôme vérifient le système linéaire :

$$
\begin{pmatrix}
S_1 & S_2 & \cdots & S_V \\
S_2 & S_3 & & S_{V+1} \\
\vdots & & \ddots & \vdots \\
S_V & S_{V+1} & \cdots & S_{2V-1}
\end{pmatrix}
\cdot
\begin{pmatrix}
\sigma_V \\
\sigma_{V-1} \\
\vdots \\
\sigma_1
\end{pmatrix}
= -\kappa \cdot
\begin{pmatrix}
S_{V+1} \\
S_{V+2} \\
\vdots \\
S_{2V}
\end{pmatrix}
\tag{6}
$$

Différents algorithmes existent pour résoudre le système linéaire (6), notamment l'algorithme d'Euclide et les algorithmes de type Berlekamp-Massey. L'algorithme d'Euclide est conceptuellement simple, mais sa mise en oeuvre requiert une complexité plus grande que les algorithmes de type Berlekamp-Massey. Les algorithmes de type Berlekamp-Massey résolvent le système (6) par itérations successives qui s'interprètent classiquement comme une construction récursive d'un registre à décalage à opérateurs linéaires modélisant le système (voir "Theory and Practice of Error Control Codes" de R.E. Blahut, Addison-Wesley, Reading, MA, 1993). A chaque itération, un écart de prédiction ("discrepancy") $\Delta_k$ à valeurs dans le corps CG($2^m$) est calculé pour mettre à jour le polynôme localisateur. Si cet écart $\Delta_k$ est encore non nul à l'issue de la (2t)-ième itération, l'algorithme indique un échec de décodage, le bloc reçu comportant plus de t symboles erronés.

Diverses variantes de l'algorithme de Berlekamp-Massey ont été proposées dans le but de simplifier son implémentation. L'article "VLSI Design of Inverse-Free Berlekamp-Massey Algorithm", de I.S. Reed et al, IEEE Proceedings-E, Vol. 138, N° 5, Septembre 1991, pages 295-298, propose une variante intéressante dans la mesure où elle permet de se dispenser d'inverser les écarts de prédiction $\Delta_k$. Cette variante revient à considérer une valeur a priori quelconque dans CG($2^m$) pour le coefficient $\kappa = \sigma_0$, au lieu de $\kappa = 1$ dans la version traditionnelle.

Une fois que le polynôme localisateur d'erreurs a été calculé, ses racines sont déterminées pour obtenir les positions h(v) des erreurs. Une procédure fréquemment utilisée pour cela, dite "recherche de Chien", consiste à calculer les valeurs du polynôme $\sigma(x)$ pour chacun des éléments du corps CG($2^m$), une erreur étant identifiée chaque fois que $\sigma(x) = 0$ (voir "Cyclic Decoding Procedure for the Bose-Chaudhuri-Hocquenghem Codes" par R.T. Chien, IEEE Trans. on Information Theory, Vo1.10, 1964, pages 357-363). Cette procédure consiste en un calcul récursif des valeurs $\sigma(\alpha^{1-N+n})$ pour n = 0, 1, ..., N-1 selon :

$$
\sigma(\alpha^{1-N+n}) = \sum_{u=0}^{t} \zeta_u^{(n)}
\tag{7}
$$

en exploitant les relations de récurrence $\zeta_u^{(n+1)} = \zeta_u^{(n)} \cdot \alpha^u$ pour $0 \leq u \leq t$, initialisées par $\zeta_u^{(0)} = \sigma_u \cdot \alpha^{u \cdot (1-N)}$.

Les amplitudes des erreurs sont par exemple évaluées selon l'algorithme de Forney (Voir "On Decoding BCH Codes", par G.D. Forney, IEEE Trans. on Information Theory, Vol. 11, 1965, pages 549-557). Un polynôme évaluateur d'erreurs $\omega(x)$ est défini par :

$$
\omega(x) = [S(x) \cdot \sigma(x)] \; modulo \; x^{2t} = \omega_t \cdot x^t + \omega_{t-1} \cdot x^{t-1} + \ldots + \omega_1 \cdot x + \omega_0
\tag{8}
$$

S(x) désignant le polynôme des syndromes :

$$
S(x) = \sum_{i=1}^{2t} S_i \cdot x^i
\tag{9}
$$

Les amplitudes des erreurs sont alors obtenues par :

$$e_{h(v)} = \frac{\omega(x)}{x.\sigma'(x)} \quad \text{pour } x = \alpha^{-h(v)} \hspace{3cm} (10)$$

$\sigma'(x)$ désignant la dérivée du polynôme localisateur d'erreurs. Les valeurs du dénominateur $\alpha^{1-N+n}\sigma(\alpha,^{1-N+n})$ pour n = 0, 1, ..., N-1 peuvent être obtenues simplement lors de la recherche de Chien (par une somme telle que (7) dans laquelle seuls les termes pour u impair sont sommés). Les valeurs du numérateur peuvent être obtenues par une procédure semblable à la recherche de Chien en remplaçant $\sigma_u$ par $\omega_u$ dans l'initialisation des relations de récurrence.

Lorsque le décodeur utilise un algorithme de type Berlekamp-Massey, les coefficients du polynôme évaluateur $\omega(x)$ peuvent être calculés en même temps que ceux du polynôme localisateur lors des 2t itérations de cet algorithme. Ils peuvent aussi être calculés ultérieurement selon (8).

Certains algorithmes de décodage ont été aménagés pour pouvoir prendre en compte des effacements dans les données d'entrée.

Un symbole effacé est marqué dans le bloc d'entrée pour indiquer que ce symbole n'a pas été reçu, ou qu'il a été reçu dans des conditions tellement mauvaises que sa valeur est a priori fausse. La prise en compte de ces effacements permet de réduire le nombre d'inconnues des relations (3) puisque certaines des positions h(v) sont connues.

Lorsque le polynôme localisateur d'erreurs est calculé de manière itérative selon l'algorithme de Berlekamp-Massey, la prise en compte des effacements conduit à initialiser différemment les coefficients du polynôme localisateur $\sigma(x)$ avant la première itération. Dans un codage sans effacements, ce polynôme localisateur est habituellement initialisé par $\sigma^0(x) = 1$, alors que la prise en compte des effacements conduit à l'initialiser par un polynôme de degré s dont les racines $\alpha^{-h(0)},..., \alpha^{-h(s-1)}$ sont déterminées par les positions h(0), ..., h(s-1) des s effacements considérés. L'algorithme de Berlekamp-Massey adapté pour prendre en compte les effacements est également décrit dans l'ouvrage précité de R.E. Blahut. Une version adaptée pour se dispenser des calculs d'inverse dans le corps de Galois est décrite dans l'article « On Decoding of Both Errors and Erasures of a Reed-Solomon Code Using an Inverse-Free Berlekamp-Massey Algorithm », de J.H. JENG et al., IEEE Transactions on Communications, Vol. 47, No. 10, octobre 1999, pages 1488-1494.

Si s est le nombre de symboles effacés du bloc d'entrée et V le nombre de symboles erronés, l'algorithme de décodage avec gestion des effacements permet de corriger les erreurs et les effacements du bloc si $2s + V \leq 2t$, soit $s+V/2 \leq t$

Ce dernier avantage fait l'intérêt des algorithmes à effacements, qui peuvent aller jusqu'à doubler la capacité de correction du code si on a effacé 2t erreurs.

Mais cet avantage suppose que la détermination des symboles effacés soit parfaitement fiable. En pratique, cette condition n'est pas toujours remplie. En particulier, il y a une probabilité d'effacer des symboles qui se trouvaient avoir été bien reçus. Dans un tel cas, si le nombre de symboles erronés était à l'origine inférieur ou égal à t, on peut dépasser les capacités de correction de l'algorithme à effacements alors que l'algorithme sans effacement aurait fourni le bon résultat.

Dans "Error Control Techniques Applicable to HF Channels" (IEE Proceedings, Vol. 136, Part. 1, No. 1, 1989, pages 57-63, S. D. Bate et al. divulguent un algorithme de décodage à décisions souples pour des codes produits construits avec des codes élémentaires de type de Reed-Solomon.

Dans "Successive-Erasure Decoding of RS Codes and Error Detection for ARQ" (Proc. of the 9th IEEE International Symposium on Personal, Indoor and Mobile Radio Communications (PIMRC'98), Boston, MA, USA, 8-11 septembre 1998), F. Poegel et al. divulguent une technique de décodage à décisions souples pour les codes de Reed-Solomon, capable de gérer des erreurs de canal avec ou sans effacements. Cette technique stoppe les itérations de décodage de l'algorithme de décodage à effacements successifs après le premier décodage réussi.

Un but de la présente invention est d'optimiser les capacités de décodage de codes correcteurs d'erreurs tels que les codes de type Reed-Solomon ou BCH (Bose-Chaudhuri-Hocquenghem).

L'invention propose ainsi un dispositif tel que défini dans la revendication 1. Des modes de réalisation préférés en sont énoncés dans les revendications 2 à 6.

Ce dispositif pallie la limitation évoquée ci-dessus des algorithmes à gestion des effacements, en garantissant que le décodage s'opère toujours dans de bonnes conditions lorsque le bloc d'entrée ne comporte pas plus de t symboles erronés. Dans certains cas où il y a plus de t symboles erronés, le second décodage à effacement permettra la bonne correction.

Le décodage proposé prend donc en considération une probabilité de se tromper dans le positionnement des effacements. Le schéma est donc bien adapté à des procédés de réception de signaux à faible rapport signal/bruit.

Il est à noter qu'on a pas besoin de calculer deux fois les syndromes lorsque les deux méthodes de corrections doivent être appliquées sur le même bloc. Comme le calcul des syndromes représente une proportion importante de la complexité de l'ensemble du décodage (environ 50%), le gain procuré par le procédé est obtenu au prix d'une augmentation raisonnable de la complexité.

D'autres particularités et avantages de la présente invention apparaîtront dans la description ci-après d'exemples de réalisation non limitatifs, en référence aux dessins annexés, dans lesquels :

- la figure 1 est un schéma synoptique d'un exemple de dispositif selon l'invention ; et
- la figure 2 est un organigramme illustrant un procédé de décodage selon l'invention.

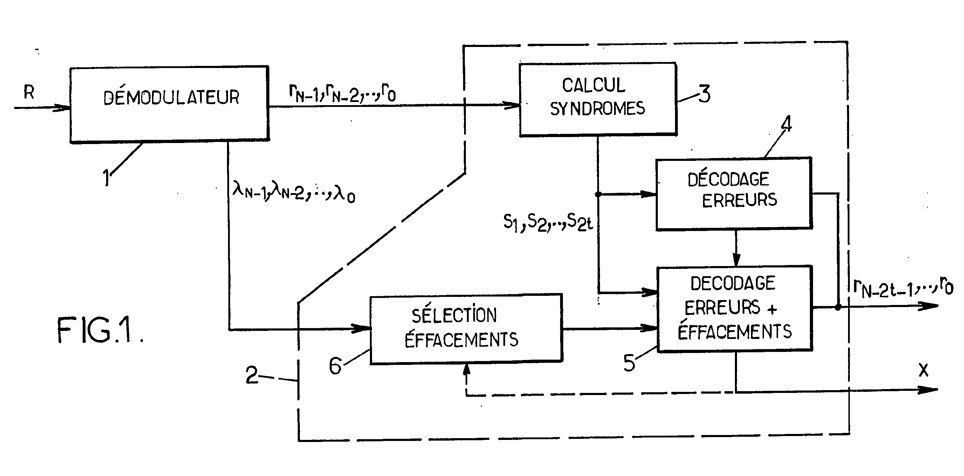

Le dispositif représenté sur la figure 1 traite un signal numérique d'entrée R qui a pu par exemple être transmis sur une interface radio. Ce signal R est fourni à un démodulateur 1 qui procède à une estimation de symboles numériques transmis. Ces symboles numériques ont été générés au niveau d'un émetteur non représenté en appliquant un codage à redondance, afin de protéger les symboles d'information contre des erreurs de transmission. Le code à redondance est de préférence un code non binaire de Reed-Solomon tel que présenté en introduction.

Par commodité de réalisation, on utilise généralement des codes systématiques, c'est-à-dire que les N-2t symboles d'information se trouvent explicitement dans les N symboles transmis. Ce sont par exemple les N-2t premiers symboles.

Le démodulateur 1 fournit les symboles estimés $r_{N-1}$, $r_{N-2}$, ... , $r_1$, $r_0$ par blocs de N symboles à un décodeur 2. Chaque symbole est constitué de m bits lorsque le code de Reed-Solomon est défini sur le corps $CG(2^m)$.

Le décodeur 2 comporte un module 3 de calcul de syndromes, qui calcule de façon classique les 2t syndromes d'erreur $S_1$, $S_2$, ..., $S_{2t}$, par exemple selon la relation (4).

Le décodeur 2 comporte en outre un module 4 de décodage d'erreurs sans prise en compte d'effacements. Celui-ci peut fonctionner de façon classique selon les algorithmes de Berlekamp-Massey, de Chien et de Forney pour corriger d'éventuelles erreurs, en nombre inférieur ou égal à t, dans les symboles estimés du bloc d'entrée. Les N-2t premiers symboles sont extraits après correction pour être fournis aux circuits d'exploitation situés en aval.

Un autre module de décodage 5 du décodeur 2 prend en compte à la fois des erreurs et des effacements lorsque le premier module 4 indique qu'il a été incapable de corriger le bloc en raison de la détection d'un nombre d'erreurs supérieur à t. Le module 5 fonctionne en utilisant les mêmes syndromes $S_1$, ..., $S_{2t}$ qui ont été calculés par le module 3, et en initialisant le polynôme localisateur d'erreurs selon un polynôme d'initialisation $\sigma^0(x)$ fourni par un module 6 de sélection d'effacements.

Si le module de décodage 5 est également mis en défaut, il délivre un signal d'alarme X pour indiquer la perte d'un bloc aux circuits situés en aval.

Le module 6 de sélection des effacements fonctionne de façon connue sur la base de mesures de vraisemblance $\lambda_{N-1}$, $\lambda_{N-2}$,..., $\lambda_1$, $\lambda_0$ fournies par le démodulateur 1 parallèlement aux symboles estimés $r_{N-1}$, $r_{N-2}$, ... , $r_1$, $r_0$. Ces mesures de vraisemblance ont par exemple été produites à partir de la métrique d'un égaliseur de canal à sorties souples du démodulateur 1 (voir par exemple EP-A-0 946 014).

A partir des positions des symboles effacés, le module 6 calcule le polynôme d'initialisation $\sigma^0(x)$ pour l'algorithme de Berlekamp-Massey mis en oeuvre par le module de décodage 5.

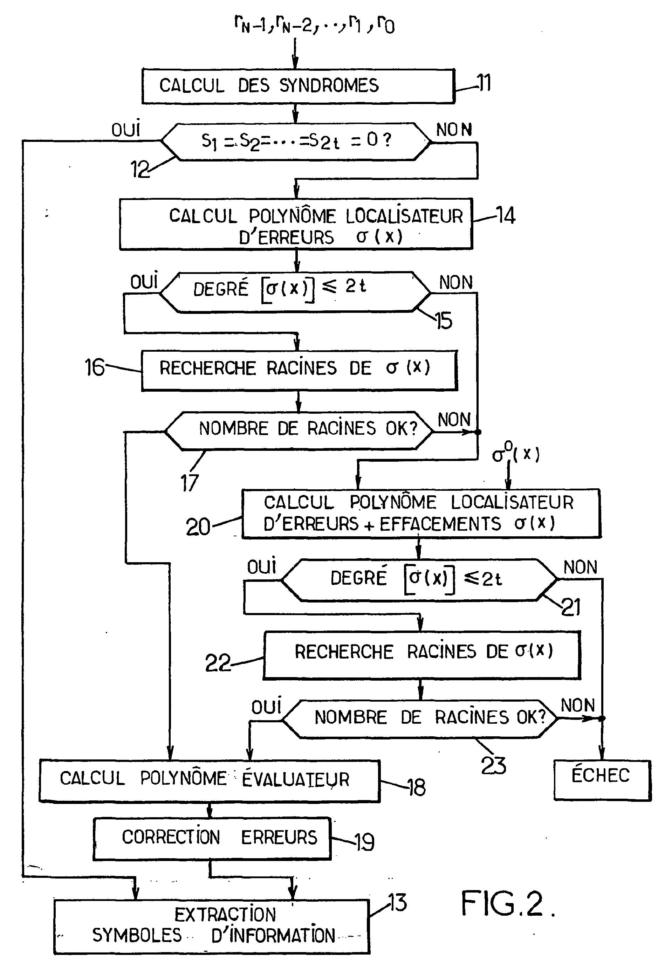

La figure 1 donne une représentation synoptique du dispositif selon l'invention. En pratique, le décodeur 2 sera souvent réalisé en programmant un processeur de signal numérique de manière appropriée, par exemple selon l'organigramme de la figure 2.

La première étape du traitement d'un bloc $r_{N-1}$, $r_{N-2}$, ..., $r_1$, $r_0$ est le calcul 11 des syndromes $S_1$, $S_2$, ..., $S_{2t}$ selon les relations (4). Si tous les syndromes sont nuls (test 12), le traitement du bloc est terminé, et il suffit d'extraire les symboles d'information du bloc (étape 13).

Si l'un au moins des syndromes n'est pas nul, le polynôme localisateur d'erreurs $\sigma(x)$ est calculé à l'étape 14, par exemple selon l'algorithme de Berlekamp-Massey initialisé par $\sigma^0(x) = 1$. Cet algorithme indique de façon classique les blocs pour lesquels il estime que le degré du polynôme localisateur d'erreurs est supérieur au degré 2t du polynôme générateur du code. Cette condition est testée à l'étape 15. Si le degré ne dépasse pas 2t, l'étape suivante est la recherche des racines du polynôme localisateur d'erreur $\sigma(x)$ à l'étape 16, par exemple selon l'algorithme de Chien. Si le nombre de racines trouvé est égal au degré du polynôme $\sigma(x)$ (test 17), l'étape suivante 18 consiste en le calcul du polynôme évaluateur $\omega(x)$, selon la relation (8). A l'étape suivante 19, l'algorithme de Forney est utilisé pour évaluer les amplitudes des erreurs, et ces amplitudes sont soustraites des symboles correspondants pour les corriger. Les symboles d'information peuvent alors être extraits du bloc à l'étape 13.

Quand l'algorithme de décodage sans effacements est mis en défaut, c'est-à-dire quand le degré du polynôme $\sigma(x)$ dépasse 2t (test 15), ou lorsque la recherche de Chien ne fournit pas le bon nombre de racines (test 17), le décodeur applique la méthode de décodage avec gestion des effacements. Il commence par calculer le polynôme localisateur d'erreurs et d'effacements (également noté $\sigma(x)$ sur la figure 2) à partir des mêmes syndromes calculés à l'étape 11 et du polynôme d'initialisation $\sigma^0(x)$ (étape 20). Ce calcul est effectué selon un algorithme de Berlekamp-Massey modifié pour prendre en compte les effacements. Le décodeur est mis en échec si le degré du polynôme localisateur $\sigma(x)$ obtenu

dépasse encore 2t lors du test 21. Sinon, le décodeur passe à la recherche 22 des racines du polynôme σ(x) selon l'algorithme de Chien. Le décodeur est encore mis en échec si le nombre de racines trouvées ne correspond pas au degré au polynôme σ(x). Sinon, il procède à l'étape 18 précitée pour déterminer le polynôme évaluateur d'erreurs et d'effacements.

En variante, le polynôme évaluateur ω(x) peut être calculé au cours de l'exécution de l'algorithme de Berlekamp-Massey, à l'étape 14 ou 20.

Dans une autre réalisation du décodeur, lorsque le décodage avec effacements est mis en défaut, le module 5 le signale au module 6 de sélection des effacements. Celui-ci sélectionne alors davantage d'effacements dans le bloc, et il détermine un polynôme d'initialisation $\sigma^0(x)$ de degré supérieur. L'algorithme de décodage à effacements est exécuté de nouveau à partir de ce polynôme $\sigma^0(x)$, toujours avec les mêmes syndromes $S_1$, ..., $S_{2t}$, pour essayer encore de corriger le bloc.

## Revendications

1. Dispositif de traitement de signal, comprenant des moyens (1) de réception du signal pour estimer des blocs de symboles d'entrée ($r_{N-1}$, $r_{N-2}$, ..., $r_1$, $r_0$) et des moyens (2) de décodage desdits blocs au moyen d'un code correcteur d'erreurs, dans lequel les moyens de décodage comprennent des moyens (3) de calcul de syndromes ($S_1$, $S_2$, ..., $S_{2t}$) à partir d'un bloc de signal et des premiers moyens (4) de traitement des syndromes pour estimer des symboles d'information, les premiers moyens de traitement des syndromes comprenant des moyens (4) de correction d'erreurs dans le bloc de signal, dans lequel les moyens de réception du signal (1) sont agencés pour fournir une information sur la fiabilité des symboles d'entrée du bloc, et les moyens de décodage (2) comprennent en outre des moyens (6) pour déterminer au moins une position d'effacement dans le bloc sur la base de ladite information sur la fiabilité, et des seconds moyens (5) de traitement des syndromes et de ladite au moins une position d'effacement, activés en réponse à une indication d'incapacité de correction par les premiers moyens de traitement (4), pour estimer les symboles d'information.

2. Dispositif selon la revendication 1, dans lequel le code correcteur d'erreurs est un code de Reed-Solomon.

3. Dispositif selon la revendication 1 ou 2, dans lequel les premiers moyens de traitement (4) comprennent des moyens de calcul d'un polynôme localisateur d'erreurs sur la base des syndromes ($S_1$, $S_2$, ...,$S_{2t}$), incluant des moyens pour générer une indication d'incapacité de correction lorsque le degré du polynôme localisateur d'erreurs dépasse le degré du polynôme générateur du code.

4. Dispositif selon la revendication 3, dans lequel les premiers moyens de traitement (4) comprennent des moyens de recherche de racines du polynôme localisateur d'erreurs, incluant des moyens pour générer une indication d'incapacité de correction lorsque le nombre de racines trouvées n'est pas égal au degré du polynôme localisateur d'erreurs.

5. Dispositif selon l'une quelconque des revendications précédentes, dans lequel les moyens de réception comprennent un démodulateur (1).

6. Dispositif selon l'une quelconque des revendications précédentes, dans lequel les moyens (6) de détermination de positions d'effacement sont agencés pour déterminer un nombre augmenté de positions d'effacement dans le bloc en réponse à une indication d'incapacité de correction par les seconds moyens de traitement (5), ledit nombre augmenté de positions d'effacement étant alors pris en compte comme paramètres d'entrée des seconds moyens de traitement pour estimer les symboles d'information.

## Claims

1. A signal processing device, comprising means (1) for receiving the signal so as to estimate blocks of input symbols ($r_{N-1}$, $r_{N-2}$, ..., $r_1$, $r_0$) and means (2) for decoding said blocks by means of an error corrector code, wherein the decoding means comprise means (3) for calculating syndromes ($S_1$, $S_2$, ... , $S_{2t}$) from a signal block and first means (4) for processing the syndromes so as to estimate information symbols, the first means for processing the syndromes comprising means (4) for correcting errors in the signal block wherein the means for receiving the signal (1) are designed to provide information about the reliability of the input symbols of the block, and the decoding means (2) furthermore comprise means (6) for determining at least one erasure position in the block on the basis of said information about the reliability, and second means (5) for processing the syndromes and said at least one erasure position, which means are activated in response to an indication of inability to correct by the first processing means (4), so as to estimate the information symbols.

2. The device as claimed in claim 1, wherein the error corrector code is a Reed-Solomon code.

3. The device as claimed in claim 1 or 2, wherein the first processing means (4) comprise means for calculating an error locator polynomial based on the syndromes ($S_1$, $S_2$, ..., $S_{2t}$), including means for generating an indication of inability to correct when the degree of the error locator polynomial exceeds the degree of the generating polynomial of the code.

4. The device as claimed in claim 3, wherein the first processing means (4) comprise means for searching for roots of the error locator polynomial, including means for generating an indication of inability to correct when the number of roots found is not equal to the degree of the error locator polynomial.

5. The device as claimed in any of the previous claims, wherein the receiving means comprise a demodulator (1).

6. The device as claimed in any of the previous claims, wherein the means for determining erasure positions are designed to determinate an increased number of erasure positions in the block in response to an indication of inability to correct by the second processing means (5), the said increased number of erasure positions being taken into account as input parameters of the second processing means, so as to estimate the information symbols.

**Patentansprüche**

1. Vorrichtung zur Signalverarbeitung, umfassend Mittel (1) zum Empfangen des Signals, um Blöcke von Eingangssymbolen ($r_{N-1}$, $r_{N-2}$, ..., $r_1$, $r_0$) zu schätzen, und Mittel (2) zum Dekodieren dieser Blöcke mit Hilfe eines Fehlerkorrekturcodes, bei der die Decodiermittel Mittel (3) zum Berechnen von Syndromen ($S_1$, $S_2$, ... , $S_{2t}$) aus einem Signalblock und erste Mittel (4) zur Verarbeitung der Syndrome umfassen, um Informationssymbole zu schätzen, wobei die ersten Mittel zur Verarbeitung der Syndrome Mittel (4) zur Korrektur von Fehlern in dem Signalblock umfassen, bei der die Mittel (1) zum Empfangen des Signals ausgebildet sind, um eine Information über die Zuverlässigkeit der Eingangssymbole des Blocks zu liefern, und die Decodiermittel (2) außerdem Mittel (6) zum Bestimmen mindestens einer Löschposition in dem Block auf der Basis dieser Information über die Zuverlässigkeit und zweite Mittel (5) zur Verarbeitung der Syndrome und dieser mindestens einen Löschposition umfassen, die als Antwort auf eine Korrekturunfähigkeitsangabe durch die ersten Verarbeitungsmittel (4) aktiviert werden, um die Informationssymbole zu schätzen.

2. Vorrichtung nach Anspruch 1, bei der der Fehlerkorrekturcode eine Reed-Solomon-Code ist.

3. Vorrichtung nach Anspruch 1 oder 2, bei der die ersten Verarbeitungsmittel (4) Mittel zur Berechnung eines Polynoms zur Lokalisierung von Fehlern auf der Basis der Syndrome ($S_1$, $S_2$, ... , $S_{2t}$) umfassen, die Mittel zum Erzeugen einer Korrekturunfähigkeitsangabe einschließen, wenn der Grad des Fehlerlokalisierungspolynoms den Grad des den Code erzeugenden Polynoms überschreitet.

4. Vorrichtung nach Anspruch 3, bei der die ersten Verarbeitungsmittel (4) Mittel zum Suchen von Wurzeln des Fehlerlokalisierungspolynoms umfassen, die Mittel zum Erzeugen einer Korrekturunfähigkeitsangabe einschließen, wenn die Anzahl von gefundenen Wurzeln nicht gleich dem Grad des Fehlerlokalisierungspolynoms ist.

5. Vorrichtung nach einem der vorhergehenden Ansprüche, bei der die Empfangsmittel einen Demodulator (1) umfassen.

6. Vorrichtung nach einem der vorhergehenden Ansprüche, bei der die Mittel (6) zum Bestimmen von Löschpositionen ausgebildet sind, um eine erhöhte Anzahl von Löschpositionen in dem Block als Antwort auf eine Korrekturunfähigkeitsangabe durch die zweiten Verarbeitungsmittel (5) zu bestimmen, wobei diese erhöhte Anzahl von Löschpositionen nun als Eingangsparameter der zweiten Verarbeitungsmittel berücksichtigt werden, um die Informationssymbole zu schätzen.

FIG.1.

EP 1 338 092 B1

$$r_{N-1}, r_{N-2}, \cdots, r_1, r_0$$

```
CALCUL DES SYNDROMES ──11

OUI          S₁ = S₂ = ⋯ = S₂ₜ = 0 ?          NON
     12

CALCUL POLYNÔME LOCALISATEUR ──14
     D'ERREURS   σ(x)

OUI   DEGRÉ [σ(x)] ≤ 2t           NON
                                      15

16── RECHERCHE RACINES DE σ(x)

NOMBRE DE RACINES OK?   NON
     17                          σ⁰(x)

CALCUL  POLYNÔME  LOCALISATEUR
20──   D'ERREURS + EFFACEMENTS σ(x)

OUI      DEGRÉ [σ(x)] ≤ 2t       NON
                                    21

22──  RECHERCHE RACINES DE σ(x)

OUI   NOMBRE DE RACINES OK?   NON
                         23

CALCUL POLYNÔME ÉVALUATEUR ──18        ÉCHEC

CORRECTION ERREURS ──19

EXTRACTION ──13
SYMBOLES D'INFORMATION
```

$S_1 = S_2 = \cdots = S_{2t} = 0\,?$

DEGRÉ $[\sigma(x)] \leq 2t$

$\sigma^0(x)$

DEGRÉ $[\sigma(x)] \leq 2t$

FIG.2.